# EUROPÄISCHE PATENTSCHRIFT

(11) **EP 2 606 516 B1**
(45) Veröffentlichungstag und Bekanntmachung des Hinweises auf die Patenterteilung: **13.01.2016**
(21) Anmeldenummer: 11744009.9
(22) Anmeldetag: 12.08.2011
(51) Int. Cl.: H01L 35/32, H01L 35/34

(54) **ROHRFÖRMIGES THERMOELEKTRISCHES MODUL SOWIE VERFAHREN ZU DESSEN HERSTELLUNG**
TUBULAR THERMOELECTRIC MODULE AND METHOD FOR PRODUCING SAID MODULE
MODULE THERMOÉLECTRIQUE TUBULAIRE ET PROCÉDÉ DE FABRICATION DUDIT MODULE

(30) Priorität: 18.08.2010 DE 102010034708
(43) Veröffentlichungstag der Anmeldung: 26.06.2013
(73) Patentinhaber: Continental Automotive GmbH, 30165 Hannover (DE)
(72) Erfinder: MÜLLER, Wilfried, 51789 Lindlar (DE)
(86) Internationale Anmeldenummer: PCT/EP2011/063908
(87) Internationale Veröffentlichungsnummer: WO 2012/022684

(56) Entgegenhaltungen:
- EP-A1- 1 780 808
- WO-A1-88/05964
- JP-A- 9 224 387
- JP-A- 10 335 710
- JP-A- 61 254 082
- US-A- 3 269 872
- US-A- 5 228 923
- US-A1- 2005 172 993
- US-A1- 2010 031 987
- US-A1- 2010 147 351

## Beschreibung

Die vorliegende Erfindung betrifft ein rohrförmiges thermoelektrisches Modul sowie ein Verfahren zur Herstellung eines thermoelektrischen Moduls. Dieses thermoelektrische Modul dient der Erzeugung elektrischer Energie z. B. aus dem Abgas einer Verbrennungskraftmaschine eines Kraftfahrzeugs mittels eines Generators. Damit ist insbesondere ein Generator zur Umwandlung thermischer Energie eines Abgases in elektrische Energie gemeint, also ein sogenannter thermoelektrischer Generator.

Das Abgas aus einem Motor eines Kraftfahrzeugs besitzt thermische Energie, welche mittels eines thermoelektrischen Generators in elektrische Energie umgewandelt werden kann, um bspw. eine Batterie oder einen anderen Energiespeicher zu füllen oder elektrischen Verbrauchern die benötigte Energie direkt zuzuführen. Damit wird das Kraftfahrzeug mit einem verbesserten energetischen Wirkungsgrad betrieben und es steht für den Betrieb des Kraftfahrzeugs Energie in größerem Umfang zur Verfügung.

Ein solcher thermoelektrischer Generator weist zumindest ein thermoelektrisches Modul auf. Thermoelektrische Materialien sind von einer Art, dass diese effektiv thermische Energie in elektrische Energie umwandeln können (Seebeck-Effekt) und umgekehrt (Peltier-Effekt). Solche thermoelektrischen Module weisen bevorzugt eine Vielzahl von thermoelektrischen Elementen auf, die zwischen einer sogenannten Heißseite und einer sogenannten Kaltseite positioniert sind. Thermoelektrische Elemente umfassen z. B. wenigstens zwei Halbleiterelemente (p-dotiert und n-dotiert), die auf ihrer Oberseite und Unterseite hin zur Heißseite bzw. zur Kaltseite wechselseitig mit elektrisch leitenden Brücken versehen sind. Keramikplatten bzw. Keramikbeschichtungen und/oder ähnliche Materialien dienen zur Isolierung der elektrisch leitenden Brücken gegenüber einem das thermoelektrische Modul umschließenden Gehäuse und sind somit bevorzugt zwischen diesen elektrisch leitenden Brücken angeordnet, so dass die Halbleiterelemente gegenüber dem Gehäuse eines thermoelektrischen Moduls bzw. gegeneinander isoliert sind. Wird ein Temperaturgefälle beidseits der Halbleiterelemente bereitgestellt, so bildet sich zwischen den Enden des Halbleiterelements ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind zahlreiche Halbleiterelemente elektrisch in Reihe geschaltet. Damit sich die generierte Potentialdifferenz der seriellen Halbleiterelemente nicht gegenseitig aufhebt, sind stets wechselweise Halbleiterelemente mit unterschiedlichen Majoritätsladungsträgern (n-dotiert und p-dotiert) in direkten elektrischen Kontakt gebracht. Mittels eines angeschlossenen Lastwiderstands kann der Stromkreis geschlossen und somit elektrische Leistung abgegriffen werden.

US 2010/0147351 A beschreibt ein rohrförmig aufgebautes thermoelektrisches Modul, wobei dieser Aufbau insbesondere unter Berücksichtigung von Problemen der Wärmeleitung und Wärmeausdehnung gewählt wurde. Mit der dortigen Maßgabe sind nur n-dotierte oder nur p-dotierte Elemente miteinander elektrisch leitend verschaltet. Insbesondere wird dort ausgeführt, dass die elektrisch leitenden Verbindungen sich jeweils zwischen der Kaltseite und der Heißseite erstrecken und so nebeneinander angeordneten Halbleiterelemente elektrisch leitend miteinander verbinden. Gerade die mit dem dortigen Aufbau erforderliche elektrische Verschaltung der Elemente ist komplex, vielteilig und schwer zu montieren.

In der JP 09-224387 A wird eine ähnliche Anordnung von Halbleiterelementen an einer sogenannten "heat pipe" vorgeschlagen.

US 5228923 offenbart eine Anordnung von Halbleiterelementen, die in Umfangsrichtung in Reihe geschaltet sind.

US 3269872 offenbart eine schneckenartige Anordnung von elektrisch leitenden Verbindungen an Innenseiten und Außenseiten von Halbleiterelementen. Die Halbleiterelemente sind elektrisch in Reihe geschaltet.

Es ist bereits versucht worden, entsprechende thermoelektrische Generatoren für die Anwendung in Kraftfahrzeugen, insbesondere Personenkraftfahrzeugen, bereitzustellen. Diese waren jedoch meist sehr teuer in der Herstellung und gekennzeichnet durch einen relativ geringen Wirkungsgrad. Damit konnte noch keine Serientauglichkeit erlangt werden.

Hiervon ausgehend ist es Aufgabe der vorliegenden Erfindung, die mit Bezug auf den Stand der Technik geschilderten Probleme zumindest teilweise zu lösen. Insbesondere soll ein thermoelektrisches Modul angegeben werden, das mit einem kostengünstigen Verfahren herstellbar ist und insbesondere in einfacher Art und Weise mit anderen thermoelektrischen Modulen verschaltbar ist, und somit einen thermoelektrischen Generator bilden kann. Weiterhin soll ein Verfahren zur Herstellung eines thermoelektrischen Moduls angegeben werden, das kostengünstig und für die Serienfertigung solcher thermoelektrischen Module besser geeignet ist.

Diese Aufgaben werden gelöst mit einem thermoelektrischen Modul gemäß den Merkmalen des Patentanspruchs 1 und durch ein Verfahren zur Herstellung eines thermoelektrischen Moduls gemäß den Merkmalen des Patentanspruchs 3.

Vorteilhafte Ausgestaltungen der Erfindung sowie die Integration dieser Erfindung in übergeordnete Baueinheiten und deren Verwendung sind in den abhängig formulierten Patentansprüchen bzw. in der Beschreibung angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Das erfindungsgemäße rohrförmige thermoelektrische Modul weist zumindest ein Innenrohr, ein Außenrohr und einen dazwischen angeordneten Zwischenraum auf. In dem Zwischenraum sind zumindest eine Mehrzahl von Ringen, die jeweils durch eine Mehrzahl abwechselnd in einer Umfangsrichtung angeordneter n-dotierter und p-dotierter Halbleiterelemente gebildet sind, hintereinander in einer axialen Richtung des thermoelektrischen Moduls angeordnet. Weiter verlaufen an einer Innenseite oder einer Außenseite der Halbleiterelemente eines Rings elektrisch leitende erste Verbindungen nur in der Umfangsrichtung, wobei auf der gegenüberliegenden Außenseite oder Innenseite zumindest eine elektrisch leitende zweite Verbindung ein Halbleiterelement des Rings mit einem Halbleiterelement eines benachbarten Rings elektrisch leitend verbindet. Diese elektrisch leitende zweite Verbindung verläuft zumindest in einer axialen Richtung des thermoelektrischen Moduls.

Insbesondere weist das rohrförmige thermoelektrische Modul kreisrunde, elliptische oder auch polygonale, im Wesentlichen konzentrisch zueinander angeordnete Außenrohre und Innenrohre auf. Die in Umfangsrichtung in dem Zwischenraum wechselweise angeordneten n-dotierten und p-dotierten Halbleiterelemente sind durch elektrisch leitende erste Verbindungen über ihre Außenseiten oder ihre Innenseiten miteinander verbunden. Die benachbarten n-dotierten und p-dotierten Halbleiterelemente sind dabei in dem Zwischenraum insbesondere durch eine elektrische Isolierung voneinander getrennt und beabstandet voneinander angeordnet. Diese elektrische Isolierung wird bevorzugt durch Luft bzw. ein Vakuum realisiert, kann aber auch z. B. durch ein Glimmermaterial oder eine Keramik gebildet werden.

Die innerhalb eines Rings vorliegende elektrisch leitende erste Verbindung verläuft an einer Innenseite oder an einer Außenseite der Halbleiterelemente ausschließlich in Umfangsrichtung. Insbesondere ist entsprechend nur an einer Stelle des Rings an einer Außenseite oder an einer Innenseite eine elektrisch leitende zweite Verbindung zwischen einem n-dotierten und einem p-dotieren Halbleiterelement, die jeweils einem benachbarten Ring zugeordnet sind, ausgebildet. Diese elektrisch leitende zweite Verbindung verläuft zumindest in einer axialen Richtung des thermoelektrischen Moduls. Insbesondere verläuft die elektrisch leitende zweite Verbindung gleichzeitig auch in Umfangsrichtung des thermoelektrischen Moduls. Eine derartige Anordnung ist insbesondere dann gegeben, wenn n-dotierte und p-dotierte Halbleiterelemente in jedem zumindest benachbarten Ring an einer identischen Umfangskoordinate in dem Zwischenraum des rohrförmigen thermoelektrischen Moduls angeordnet sind. Die Verbindung eines dann benachbarten n- dotierten und p-dotierten Halbleiterelements, die benachbarten Ringen zugeordnet sind, erfolgt durch eine elektrisch leitende zweite Verbindung, die dann einerseits in axialer Richtung den Abstand zwischen den benachbarten Ringen überwindet und andererseits in Umfangsrichtung einen Versatz erzeugt, so dass unterschiedlich dotierte Halbleiterelemente miteinander verbunden sind. Diese elektrisch leitende zweite Verbindung kann entweder auf der Innenseite oder auf der Außenseite vorgesehen sein. Insbesondere ist diese elektrisch leitende zweite Verbindung bei allen auf dem thermoelektrischen Modul angeordneten Ringen identisch ausgeführt, ganz besonders bevorzugt auch identisch hinsichtlich der Position in Umfangsrichtung, als auch identisch hinsichtlich der Anordnung an einer Außenseite oder an einer Innenseite der Halbleiterelemente.

Insbesondere sind an den jeweiligen Enden des thermoelektrischen Moduls entsprechende Kontakte ausgeführt, so dass eine elektrisch leitende Verbindung zu anderen thermoelektrischen Modulen und/oder zu einem elektrischen System, z. B. zu einem thermoelektrischen Generator oder zu einer Stromversorgung eines Kraftfahrzeugs, gewährleistet werden kann. Diese Kontakte sind bevorzugt ebenfalls an den vorgenannten identischen Positionen angeordnet.

Im Ergebnis bedeutet das mit anderen Worten, dass an der Innenseite/Außenseite sehr einfache erste Verbindungen nur in Umfangsrichtung entlang der Ringe ausgebildet werden müssen, so dass ein einfacher Herstellungsprozess hierfür herangezogen werden kann. Die elektrische Reihenschaltung der benachbarten Ringe erfolgt dann nur auf der anderen Seite (Außenseite/Innenseite) mittels der zweiten Verbindung, so dass hier eine asymmetrische Ausprägung der elektrisch leitenden Verbindungen innen und außen realisiert ist. Damit kann aber die Position der elektrisch leitenden zweiten Verbindungen an die Montageverhältnisse einfach angepasst werden.

An einer Umfangskoordinate in einer axialen Richtung sind ausschließlich jeweils n-dotierte oder p-dotierte Halbleiterelemente angeordnet. Das bedeutet mit anderen Worten insbesondere, dass in axialer Richtung des thermoelektrischen Moduls hintereinander im Wesentlichen fluchtend nur eine Art der Halbleiterelemente angeordnet ist. Dies stellt sicher, dass für die elektrisch leitende zweite Verbindung ein Standard-Bauteil verwendet werden kann, das zwischen allen Ringen gleichermaßen exakt und einfach positioniert werden kann und sicher eine elektrische Kontaktierung erlaubt. Zudem kann so auch die Montage erleichtert werden, weil die einzelnen elektrisch leitenden zweiten Verbindungen dann auch fluchtend angeordnet werden können.

Gemäß einer vorteilhaften Ausgestaltung des thermoelektrischen Moduls ist in jedem Ring eine gerade Anzahl von Halbleiterelementen in Umfangsrichtung hintereinander im Zwischenraum angeordnet, wobei insbesondere mindestens vier Halbleiterelemente vorgesehen sind. Das heißt insbesondere, dass auch sechs, acht, zehn, zwölf oder mehr Halbleiterelemente in Umfangsrichtung hintereinander im Zwischenraum angeordnet sind. Bei einer geraden Anzahl von Halbleiterelementen ist eine elektrisch leitende Verbindung der Halbleiterelemente in Umfangsrichtung so möglich, dass entlang einer axialen Richtung des rohrförmigen thermoelektrischen Moduls identische Ringe sowohl hinsichtlich der Anordnung von n-dotierten und p-dotierten Halbleiterelementen als auch hinsichtlich der Anordnung der elektrisch leitenden Verbindungen hintereinander in identischer Weise angeordnet werden können.

Die Vorteile eines derartigen rohrförmigen thermoelektrischen Moduls werden auch offensichtlich durch die nachfolgende Beschreibung des erfindungsgemäßen Verfahrens, das zur Herstellung des erfindungsgemäßen thermoelektrischen Moduls geeignet ist. Mehrere solcher thermoelektrischen Module können hintereinander angeordnet und elektrisch in Reihe kontaktiert werden. Damit können diese seriell zu einem langgestreckten thermoelektrischen Modul verbunden werden. Gleichfalls kann eine Mehrzahl solcher rohrförmiger thermoelektrischer Module parallel zueinander angeordnet werden, so dass somit ein thermoelektrischer Rohrbündelgenerator erzeugbar ist.

Das erfindungsgemäße Verfahren zum Herstellen eines thermoelektrischen Moduls weist zumindest die folgenden Schritte auf:
a) Bereitstellen eines Innenrohrs,
b) Bereitstellen eines Außenrohrs,
c) Anordnen von Halbleiterelementen zwischen dem Innenrohr und dem Außenrohr, wobei die Halbleiterelemente eine Länge in der axialen Richtung aufweisen,
d) Verbinden von Innenrohr, Außenrohr und Halbleiterelementen,
e) Einbringen von mindestens einer Trennstelle zumindest in das Außenrohr und in die Halbleiterelemente, so dass die Länge der Halbleiterelemente in zumindest zwei Abschnitte unterteilt wird.

Das Innenrohr und das Außenrohr sind insbesondere aus dem gleichen Material gefertigt. Hierzu sind z. B. Stahlwerkstoffe vorgesehen, die für Gehäuse thermoelektrischer Module eingesetzt werden können. Diese Innenrohre und Außenrohre können aber auch aus unterschiedlichen Materialien hergestellt sein. Insbesondere können Innenrohr oder Außenrohr mit einem Material bereit gestellt werden, mit dem die elektrisch leitenden ersten Verbindungen und/oder zweiten Verbindungen des thermoelektrischen Moduls ausgebildet werden, so dass diese z. B. aus einem Nickel-Werkstoff oder Molybdän-Werkstoff oder Kupfer-Werkstoff bestehen. Insbesondere ist es möglich, dass nur das Außenrohr aus einem Werkstoff zur Bildung elektrisch leitender erster Verbindungen und/oder zweiter Verbindungen besteht, so dass das Innenrohr aus einem Werkstoff zur Bildung eines Gehäuseteils ausgeführt ist. In diesem Fall kann insbesondere das Innenrohr z. B. aufgedruckte elektrisch leitende erste Verbindungen oder/und zweite Verbindungen aufweisen. Insbesondere weist das Innenrohr zusätzlich eine elektrische Isolationsschicht auf, die das Innenrohr und die elektrisch leitenden Verbindungen darauf voneinander elektrisch isoliert.

Die Halbleiterelemente sind insbesondere kreisringsegmentförmig in einer Umfangsrichtung angeordnet und erstrecken sich in der axialen Richtung über eine bestimmte Länge. Damit ist insbesondere gemeint, dass sich jeweils eine Art Barren aus einem p-dotierten und/oder n-dotierten thermoelektrischen Material entlang der axialen Richtung des Innenrohres bzw. des Außenrohres erstreckt. Die Länge dieser barrenförmigen Halbleiterelemente ist ausreichend groß, dass daraus in einem späteren Schritt des Verfahrens durch einen Trennprozess mehrere (kleinere) Halbleiterelemente herstellbar sind. Bevorzugt ist, dass die barrenförmigen Halbleiterelemente eine Länge haben, so dass sich diese über einen wesentlichen Anteil der axialen Richtung des Innenrohrs/Außenrohrs erstrecken, z. B. mindestens 50 % oder sogar mindestens 80 %. Durch den Trennprozess wird demnach bevorzugt aus einem barrenförmigen Halbleiterelement eine Mehrzahl oder sogar Vielzahl (z. B. im Wesentlichen quaderförmiger) Halbleiterelemente erzeugt. Die (barrenförmigen) Halbleiterelemente werden insbesondere auf dem Innenrohr an entsprechenden Positionen angeordnet und mit ggf. vorgesehenen elektrisch leitenden ersten Verbindungen und/oder zweiten Verbindungen verbunden. Insbesondere ist diese Verbindung stoffschlüssig ausgeführt, das heißt, ggf. ist hier ein Lotwerkstoff oder Klebstoff zwischen elektrisch leitenden Verbindungen und den Halbleiterelementen angeordnet, so dass die Halbleiterelemente hinsichtlich ihrer Position auf dem Innenrohr fixiert sind.

Das Außenrohr kann insbesondere auf das bereits mit den Halbleiterelementen verbundene Innenrohr aufgeschoben werden. Insbesondere erfolgt danach ein Kalibrierschritt, wobei der Durchmesser des Innenrohrs aufgeweitet und/oder der Durchmesser des Außenrohrs reduziert wird, so dass ein spaltfreier Zusammenbau von Halbleiterelementen, Innenrohr und Außenrohr ermöglicht werden kann.

Nachfolgend werden bevorzugt mehrere Trennstellen zumindest in das Außenrohr und in die Halbleiterelemente eingebracht, so dass die Halbleiterelemente mit einer Länge in der axialen Richtung nun in Abschnitte aufgeteilt werden, wobei innerhalb eines Abschnitts die in Umfangsrichtung wechselweise angeordneten n-dotierten und p-dotierten Halbleiterelemente jeweils einen Ring erzeugen. Durch das Einbringen von mehreren Trennstellen, die insbesondere parallel zueinander in Umfangsrichtung verlaufen, werden die Halbleiterelemente in axiale Abschnitte unterteilt und somit Ringe mit in Umfangsrichtung wechselweise angeordneten n- und p-dotierten Halbleiterelementen erzeugt. Durch das weitere Einbringen von Trennstellen in der axialen Richtung werden elektrisch leitende erste Verbindungen zwischen jeweils n- und p-dotierten Halbleiterelementen eines Rings erzeugt, so dass diese wechselweise über ihre Außenseiten bzw. ihre Innenseiten in Umfangsrichtung miteinander verbunden sind.

Gemäß einer vorteilhaften Ausgestaltung des Verfahrens erfolgt zumindest an einer Stelle eines jeden Rings das Einbringen der Trennstelle so, dass eine Verbindung von unterschiedlich dotierten Halbleiterelementen benachbarter Ringe über ihre Außenseite möglich ist. Diese elektrisch leitende zweite Verbindung verläuft dann sowohl in einer axialen Richtung, um den Abstand zweier benachbarter Abschnitte bzw. zweier benachbarter Ringe zu überbrücken als auch in Umfangsrichtung, um den Abstand zwischen dem n-dotierten und dem p-dotierten Halbleiterelement zu überwinden.

Dieser Trennprozess wird insbesondere über ein mechanisches Zerspanungsverfahren eingebracht, kann aber auch durch thermische Verfahren, wie Schweißen oder Plasmaschneiden, eingebracht werden. Weitere mögliche Verfahren sind z. B. Laserstrahlschneiden oder Wasserstrahlschneiden. Zudem können chemische Trennprozesse z. B. Erodierprozesse verwendet werden, um das Außenrohr entsprechend zu gestalten.

Durch dieses Verfahren ist es möglich, den aufwendigen Positionierungsprozess der Vielzahl von Halbleiterelementen zu vereinfachen. Es werden nur wenige langgestreckte Halbleiterelemente als Ausgangsmaterial benötigt, die in Umfangsrichtung nebeneinander auf dem zylindrischen Innenrohr anordenbar sind. Entsprechend kann ein Innenrohr vorbereitet werden, das bereits über eine ggf. benötigte Isolationsschicht und eine entsprechend aufgebrachte Leiterbahnstruktur von ersten und/oder zweiten Verbindungen verfügt. Die entsprechend aufgebrachten Halbleiterelemente können ggf. benötigte Barriereschichten aufweisen, die das Hineindiffundieren von ungewünschten Elementen, z. B. aus der elektrisch leitenden Verbindung, in das Halbleiterelementmaterial verhindern können. Andererseits können die elektrisch leitenden Verbindungen aber auch aus einem Material gefertigt sein, das eine entsprechende Diffusion verhindert bzw. bei dem eine Diffusion nicht befürchtet werden muss.

Durch das nachfolgende zumindest teilweise Trennen der Halbleiterelemente und des Außenrohrs kann eine entsprechende elektrisch leitende erste Verbindung und/oder zweite Verbindung erzeugt werden, so dass eine sichere elektrische Verbindung des gesamten thermoelektrischen Moduls realisiert ist. Mit anderen Worten bedeutet dass auch, dass mit Schritt e) gleichzeitig eine Vervielfältigung der Halbleiterelemente und eine Ausbildung des Schaltmusters der elektrisch leitenden Verbindungen erreicht werden kann. Insbesondere ist es möglich, beliebig lange Innenrohre und Außenrohre vorzusehen, auf denen mehrere quaderförmige Halbleiterelemente hintereinander in einer axialen Richtung und nebeneinander in einer Umfangsrichtung des rohrförmigen thermoelektrischen Moduls angeordnet werden.

Der Zwischenraum zwischen den Halbleiterelementen wird insbesondere nicht ausgefüllt, sondern kann im fertig hergestellten thermoelektrischen Modul mit Luft gefüllt sein oder evakuiert werden. Sowohl Luft als auch ein Vakuum oder aber auch eine Schutzgasatmosphäre erzeugt einerseits eine elektrische Isolation der Halbleiterelemente gegeneinander als auch eine sehr gute thermische Isolierung der Heißseite gegenüber der Kaltseite des thermoelektrischen Moduls. Die Heißseite des thermoelektrischen Moduls ist insbesondere auf der Seite des Innenrohrs des thermoelektrischen Moduls vorgesehen, kann aber ohne Einschränkung auch an der Seite des Außenrohrs vorgesehen sein.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Es zeigen schematisch:
- Fig. 1:: Schritt a) und b) des erfindungsgemäßen Verfahrens;
- Fig. 2:: Schritt c) des erfindungsgemäßen Verfahrens;
- Fig. 3:: einen vergrößerten Ausschnitt der Fig. 2;
- Fig. 4:: Schritt d) des erfindungsgemäßen Verfahrens; und
- Fig. 5:: das fertige thermoelektrische Modul nach Schritt e).

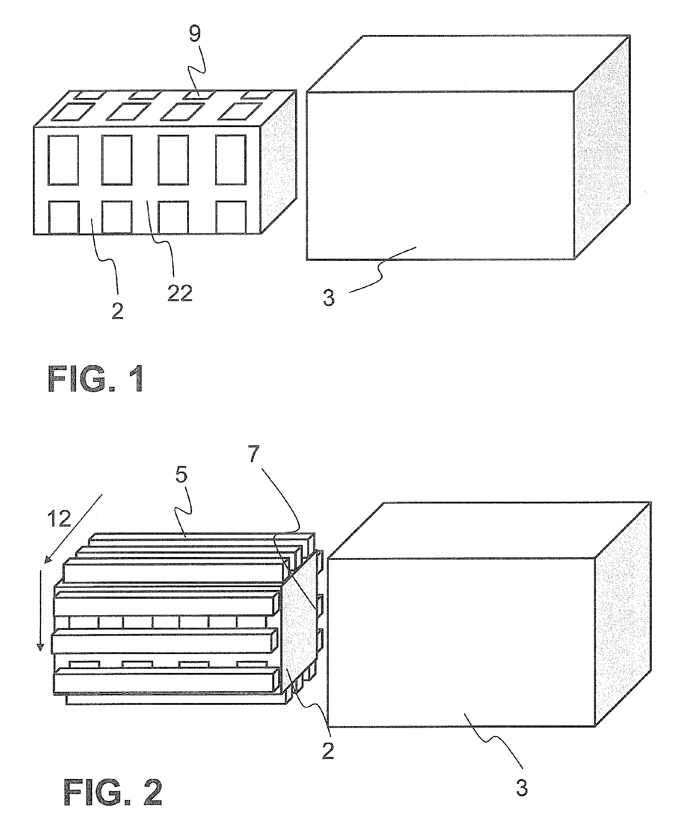

Fig. 1 zeigt ein Außenrohr 3 und ein Innenrohr 2 während Schritt a) des erfindungsgemäßen Verfahrens. Das Innenrohr 2 weist bereits elektrisch leitende erste Verbindungen 9 auf, die auf der Außenfläche des Innenrohrs 2 angeordnet sind. Auf der Außenfläche des Innenrohrs 2 ist weiterhin eine Isolationsschicht 22 angeordnet, die die elektrisch leitenden ersten Verbindungen 9 von dem (metallischen) Innenrohr 2 elektrisch isoliert.

Fig. 2 veranschaulicht Schritt b) des erfindungsgemäßen Verfahrens, wobei auf der Außenfläche des Innenrohrs 2 mehrere barrenförmige Halbleiterelemente 5 angeordnet sind. Dabei sind die Halbleiterelemente 5 so angeordnet, dass in Umfangsrichtung 12 wechselweise n-dotierte und p-dotierte Halbleiterelemente nebeneinander positioniert sind. Die elektrisch leitenden ersten Verbindungen 9 sind so angeordnet, dass die Innenseiten 7 benachbarter n-dotierter und p-dotierter Halbleiterelemente 5 elektrisch leitend miteinander verbunden sind. Diese elektrisch leitende erste Verbindung 9 der benachbarten Halbleiterelemente 5 erfolgt nur paarweise, so dass immer nur zwei Halbleiterelemente 5 miteinander über ihre Innenseite 7 durch elektrisch leitende erste Verbindungen 9 miteinander verbunden sind.

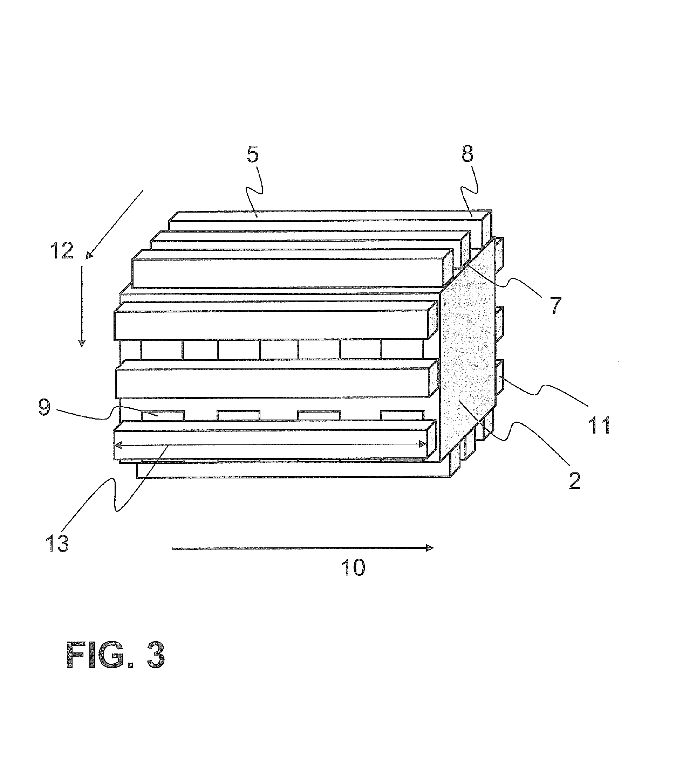

Fig. 3 zeigt das Innenrohr 2 mit Halbleiterelementen 5 aus Fig. 2 in einer Vergrößerung zur Verdeutlichung der Anordnung der Halbleiterelemente 5 auf dem Innenrohr 2. Die Halbleiterelemente 5 erstrecken sich über eine Länge 13 in der axialen Richtung 10. Die Halbleiterelemente 5 sind wechselweise in Umfangsrichtung 12 als n-dotierte und p-dotierte Halbleiterelemente 5 auf der Außenseite des Innenrohrs 2 angeordnet. Die Halbleiterelemente 5 weisen eine Innenseite 7 und eine Außenseite 8 auf, wobei die Innenseite 7 mit dem Innenrohr 2 zumindest teilweise verbunden ist und die Außenseite 8 zumindest teilweise mit dem Außenrohr verbindbar ist. An einer Umfangskoordinate 11 ist in der axialen Richtung 10 jeweils ein gleichartiges Halbleiterelement 5, also ein n-dotiertes oder ein p-dotiertes Halbleiterelement 5, angeordnet. Dies ist insbesondere zu berücksichtigen bei einer Anordnung mehrerer thermoelektrischer Module hintereinander.

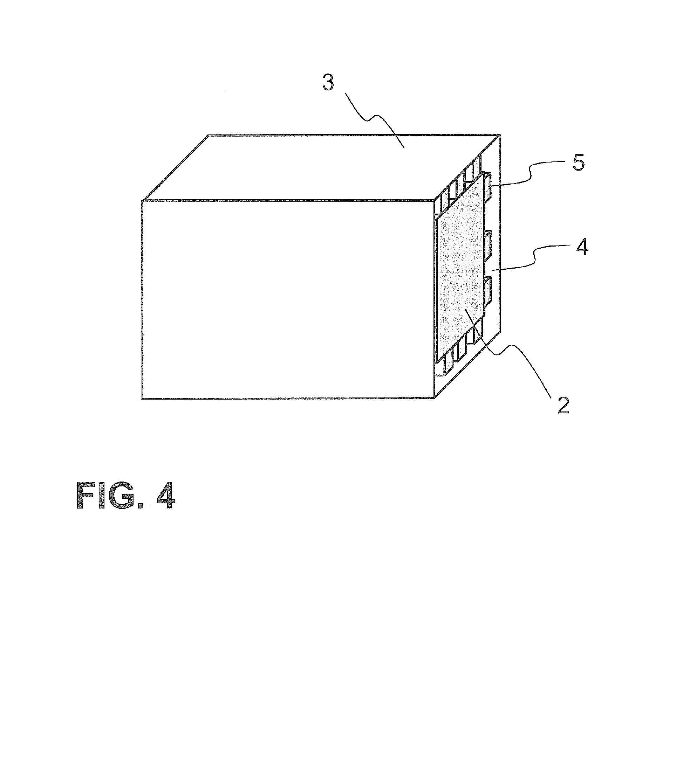

Fig. 4 veranschaulicht Schritt d) des erfindungsgemäßen Verfahrens, wobei das Außenrohr 3 über die Halbleiterelemente 5 mit dem Innenrohr 2 verbunden wird. Zwischen Außenrohr 3 und Innenrohr 2 wird der Zwischenraum 4 ausgebildet.

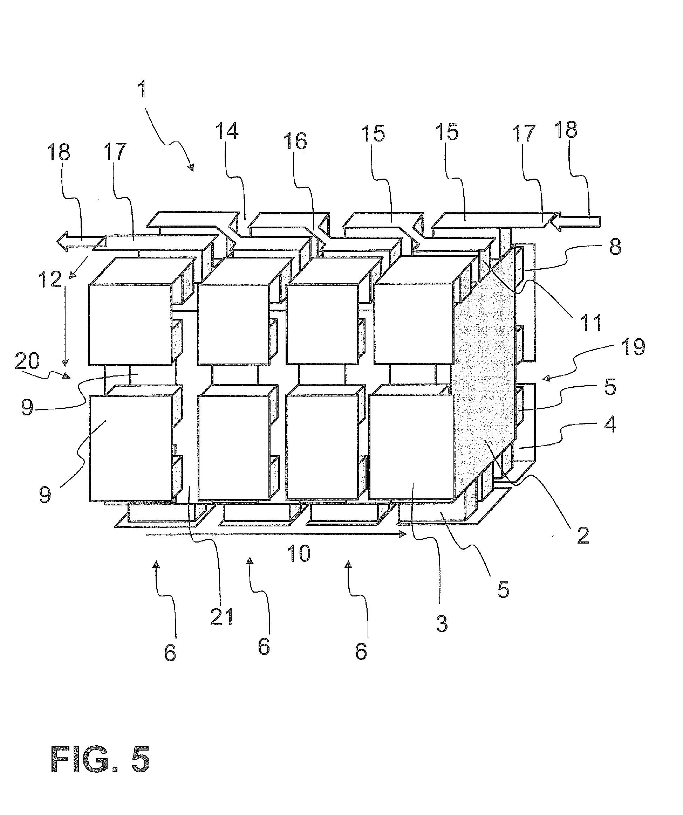

Fig. 5 zeigt das fertige thermoelektrische Modul 1 nach Schritt e) des Verfahrens. Durch einen Trennprozess ist das Außenrohr 3 in elektrisch leitende erste Verbindungen 9 und elektrisch leitende zweite Verbindungen 16 aufgeteilt, die jeweils benachbarte unterschiedlich dotierte Halbleiterelemente 5 über ihre Außenseiten 8 jeweils paarweise miteinander verbinden. Weiterhin sind die quaderförmigen Halbleiterelemente 5 durch den Trennprozess in Abschnitte 15 unterteilt worden, so dass jeweils in axialer Richtung 10 Ringe 6 mit in Umfangsrichtung 12 abwechselnd angeordneten n-dotierten und p-dotierten Halbleiterelementen 5 hintereinander angeordnet sind. An einer für jeden Ring 6 gleichen Umfangskoordinate 11 werden durch das Außenrohr 3 elektrisch leitende zweite Verbindungen 16 gebildet, die sowohl in axialer Richtung 10 als auch in Umfangsrichtung 12 verlaufen, um unterschiedlich dotierte Halbleiterelemente 5 benachbarter Ringe 6 über deren Außenseiten 8 miteinander zu verbinden. Durch diese Anordnung der elektrisch leitenden Verbindungen 9, 16 kann ein Strompfad 18 durch das thermoelektrische Modul 1 erzeugt werden, der ausgehend von einem Kontakt 17 an einer ersten Stirnseite 19 in axialer Richtung 10, in Umfangsrichtung 12 und durch die Halbleiterelemente 5 auch in radialer Richtung zu einem Kontakt 17 an einer zweiten Stirnseite 20 verläuft. Damit ist das thermoelektrische Modul 1 mit anderen gleichartigen thermoelektrischen Modulen 1 in einer seriellen Anordnung verbindbar oder kann mit anderen thermoelektrischen Modulen 1 in paralleler Anordnung einen thermoelektrischen Generator erzeugen.

Das Außenrohr 3 ist durch die Trennstellen 14 nun nach außen hin offen. Die in Fig. 5 gezeigte Anordnung kann daher durch ein weiteres Außengehäuserohr aufgenommen werden. Dieses wird insbesondere nachfolgend kalibriert, so dass eine spaltfreie Anbindung von Außengehäuserohr und Außenrohr 3 ermöglicht wird. Der Zwischenraum 4 zwischen Innenrohr 2, Außenrohr 3 bzw. Außengehäuserohr wird zum einen durch die Halbleiterelemente 5 ausgefüllt und zum anderen durch eine Isolierung 21. Diese Isolierung 21 ist bevorzugt Luft oder ein nach Aufbringen des Außengehäuserohrs induziertes Vakuum oder eine Schutzgasatmosphäre.

Durch die vorliegende Erfindung wird ein thermoelektrisches Modul vorgeschlagen, dass durch die besondere Anordnung von elektrisch leitenden ersten Verbindungen und zweiten Verbindungen eine asymmetrische Anordnung von elektrisch leitenden Verbindungen, die an einer Innenseite von Halbleiterelementen vorgesehen sind gegenüber elektrisch leitenden Verbindungen, die an einer Außenseite der Halbleiterelemente angeordnet sind, aufweist.

### Bezugszeichenliste

- 1: thermoelektrisches Modul
- 2: Innenrohr
- 3: Außenrohr
- 4: Zwischenraum
- 5: Halbleiterelement
- 6: Ring
- 7: Innenseite
- 8: Außenseite
- 9: erste Verbindung
- 10: axiale Richtung
- 11: Umfangskoordinate
- 12: Umfangsrichtung
- 13: Länge
- 14: Trennstelle
- 15: Abschnitt
- 16: zweite Verbindung
- 17: Kontakt
- 18: Strompfad
- 19: erste Stirnseite
- 20: zweite Stirnseite
- 21: Isolierung
- 22: Isolationsschicht

## Patentansprüche

1. Rohrförmiges thermoelektrisches Modul (1) zumindest aufweisend ein Innenrohr (2), ein Außenrohr (3) und einen dazwischen angeordneten Zwischenraum (4), wobei zumindest eine Mehrzahl von Ringen (6), die jeweils durch eine Mehrzahl abwechselnd in einer Umfangsrichtung angeordneter n-dotierter und p-dotierter Halbleiterelemente (5) gebildet sind, hintereinander in einer axialen Richtung (10) des thermoelektrischen Moduls (1) in dem Zwischenraum (4) angeordnet sind, wobei weiter an einer Innenseite (7) oder einer Außenseite (8) der Halbleiterelemente (5) eines Rings (6) elektrisch leitende erste Verbindungen (9) nur in der Umfangsrichtung (12) verlaufen und die benachbart angeordneten Halbleiterelemente (5) wechselweise über die Außenseite (8) oder die Innenseite (7) miteinander verbinden und auf der gegenüberliegenden Außenseite (8) oder Innenseite (7) jeweils eine elektrisch leitende zweite Verbindung (9) ein Halbleiterelement (5) des Rings (6) mit einem Halbleiterelement (5) eines benachbarten Rings (6) elektrisch leitend verbindet und in einer axialen Richtung (10) und in Umfangsrichtung (12) des thermoelektrischen Moduls (1) verläuft, wobei die Halbleiterelemente (5) und die Ringe (6) elektrisch in Reihe geschaltet sind und wobei an einer Umfangskoordinate (11) in einer axialen Richtung (10) ausschließlich jeweils n-dotierte oder p-dotierte Halbleiter elemente (5) angeordnet sind.

2. Thermoelektrisches Modul (1) nach Patentanspruch 1, wobei in jedem Ring (6) eine gerade Anzahl von Halbleiterelementen (5) in Umfangsrichtung (12) hintereinander im Zwischenraum (4) angeordnet ist, wobei mindestens vier Halbleiterelemente (5) vorgesehen sind.

3. Verfahren zum Herstellen eines thermoelektrischen Moduls (1) nach einem der vorhergehenden Patentansprüche, aufweisend zumindest die folgenden Schritte:
a) Bereitstellen eines Innenrohrs (2),
b) Bereitstellen eines Außenrohrs (3),
c) Anordnen von Halbleiterelementen (5) zwischen dem Innenrohr (2) und dem Außenrohr (3), wobei die Halbleiterelemente (5) eine Länge (13) in der axialen Richtung (10) aufweisen,
d) Verbinden von Innenrohr (2), Außenrohr (3) und Halbleiterelementen (5),
e) Einbringen von mindestens einer Trennstelle (14) zumindest in das Außenrohr (3) und in die Halbleiterelemente (5), so dass die Länge (13) der Halbleiterelemente (5) in zumindest zwei Abschnitte (15) unterteilt wird.

## Claims

1. Tubular thermoelectric module (1) at least comprising an inner tube (2), an outer tube (3) and an interspace (4) arranged therebetween, wherein at least a plurality of rings (6) each formed by a plurality of n-doped and p-doped semiconductor elements (5) arranged alternately in a circumferential direction are arranged in succession in an axial direction (10) of the thermoelectric module (1) in the interspace (4), wherein furthermore, on an inner side (7) or an outer side (8) of the semiconductor elements (5) of one ring (6), electrically conductive first connections (9) run only in the circumferential direction (12) and connect the adjacently arranged semiconductor elements (5) to one another alternately via the outer side (8) or the inner side (7) and, on the opposite outer side (8) or inner side (7), in each case one electrically conductive second connection (9) electrically conductively connects a semiconductor element (5) of the ring (6) to a semiconductor element (5) of an adjacent ring (6) and runs in an axial direction (10) and in the circumferential direction (12) of the thermoelectric module (1), wherein the semiconductor elements (5) and the rings (6) are electrically connected in series and wherein exclusively n-doped or p-doped semiconductor elements (5) in each case are arranged at a circumferential coordinate (11) in an axial direction (10).

2. Thermoelectric module (1) according to Patent Claim 1, wherein in each ring (6) an even number of semiconductor elements (5) are arranged in succession in the circumferential direction (12) in the interspace (4), wherein at least four semiconductor elements (5) are provided.

3. Method for producing a thermoelectric module (1) according to any of the preceding patent claims, comprising at least the following steps:
a) providing an inner tube (2),
b) providing an outer tube (3),
c) arranging semiconductor elements (5) between the inner tube (2) and the outer tube (3), wherein the semiconductor elements (5) have a length (13) in the axial direction (10),
d) connecting inner tube (2), outer tube (3) and semiconductor elements (5),
e) introducing at least one separating location (14) at least into the outer tube (3) and into the semiconductor elements (5), such that the length (13) of the semiconductor elements (5) is subdivided into at least two sections (15).

## Revendications

1. Module (1) thermoélectrique tubulaire ayant au moins un tuyau (2) intérieur, un tuyau (3) extérieur et un espace (4) intermédiaire disposé entre eux, dans lequel au moins une multiplicité d'anneaux (6), qui sont formés respectivement par une multiplicité d'éléments (5) à semiconducteur à dopage n et à dopage p disposés en alternance dans une direction périphérique, sont disposés dans l'espace (4) intermédiaire les uns derrière les autres dans une direction (10) axiale du module (1) thermoélectrique, dans lequel, en outre, sur un côté (7) intérieur ou un côté (8) extérieur des éléments (5) à semiconducteur d'un anneau (6), des premières liaisons (9) conductrices de l'électricité s'étendent seulement dans la direction (12) périphérique et les éléments (5) à semiconducteur disposés au voisinage sont reliées entre eux en alternance par le côté (8) extérieur ou par le côté (7) intérieur et, du côté (8) extérieur ou du côté (7) intérieur opposé, respectivement une deuxième liaison (9) conductrice de l'électricité relie d'une manière conductrice de l'électricité un élément (5) à semiconducteur de l'anneau (6) à un élément (5) à semiconducteur d'un anneau (6) voisin et s'étend, dans une direction (10) axiale et dans une direction (12) périphérique du module (1) thermoélectrique, les éléments (5) à semiconducteur et les anneaux (6) étant montés électriquement en série et des éléments (5) à semiconducteur exclusivement respectivement à dopage n ou à dopage p étant montés sur une coordonnée (11) périphérique dans une direction (10) axiale.

2. Module (1) thermoélectrique suivant la revendication 1, dans lequel, dans chaque anneau (6), un nombre pair d'éléments (5) à semiconducteur est monté dans la direction (12) périphérique successivement dans l'espace (4) intermédiaire, au moins quatre éléments (5) étant prévus.

3. Procédé de fabrication d'un module (1) thermoélectrique suivant l'une des revendications précédentes, ayant au moins les stades suivants :
a) on se procure un tuyau (2) intérieur,
b) on se procure un tuyau (3) extérieur,
c) on met des éléments (5) à semiconducteur entre le tuyau (2) intérieur et le tuyau (3) extérieur, les éléments (5) à semiconducteur ayant une longueur (13) dans la direction (10) axiale,
d) on relie le tuyau (2) intérieur, le tuyau (3) extérieur et les éléments (5) à semiconducteur,
e) on introduit au moins un point (14) de séparation, au moins dans le tuyau (3) extérieur et dans les éléments (5) à semiconducteur, de manière à subdiviser la longueur (13) des éléments (5) à semiconducteur en au moins deux tronçons (15).
